# EUROPEAN PATENT SPECIFICATION

(11) **EP 3 350 886 B1**
(45) Date of publication and mention of the grant of the patent: **04.12.2019**
(21) Application number: 16765960.6
(22) Date of filing: 13.09.2016
(51) Int. Cl.: H01R 13/14, H01R 13/46, H01R 13/66, H01R 13/717, H05K 1/18, H01R 13/641, H01R 13/70, H01R 24/86

(54) **SMART ACTIVE CONNECTOR**
SMART-ACTIVE-VERBINDER
CONNECTEUR ACTIF INTELLIGENT

(30) Priority: 14.09.2015 US 201562218401 P
(43) Date of publication of application: 25.07.2018
(73) Proprietor: Interlemo Holding S.A., 1024 Ecublens (CH)
(72) Inventor: BUECHLI, Serge, 1004 Lausanne (CH); PATENAUDE, Alexandre, 74200 Thonon-les-Bains (FR)
(74) Representative: reuteler & cie SA
(86) International application number: PCT/EP2016/071482
(87) International publication number: WO 2017/046042

(56) References cited:
- US-A1- 2004 242 087
- US-A1- 2005 215 119

## Description

### Field of the invention

The present invention relates to a connector assembly with identification capabilities for secure connection, and more particularly to a connector assembly comprising smart socket and plug connectors. The invention also relates to an identification method for secure connection between plug and socket connectors and to a connection history control method for secure connection between a socket connector and a disposable plug connector particularly adapted for use in sterilized environment such as in hospitals.

### Background of the invention

Connectors are used in various fields of industry such as equipment registration, original equipment manufacturer authentication, peripheral and accessory identification, military applications and medical equipment identification. Connection security and customizable features through the connectors themselves are however not sufficiently addressed by the prior art. Conventional connectors are for instance not well adapted for use in a sterilized environment such as in hospitals where the lifespan of plug connectors may significantly be reduced by premature wear caused by aggressive chemical composition used for sterilization. Once the connectors have been sterilized, they need to be thoroughly rinsed with sterile water in order to remove residual solution to prevent premature wear which may cause defective functioning to the connector. After sterilization, devices must be track and restocked. For prior art connectors used in surgical equipment, problem of inventory control, cross-infection risks, and operational inefficiency are part of the constant sterilization and restocking process.

US2005/215119 generally relates to a low-cost adapter panel, electronic equipment, and cable connector identification system.

US2004/242087 generally relates to plug error insertion systems that are suitable for preventing plugs from being inserted in an incorrect socket.

### Summary of the invention

In view of the forgoing, it is an object of the invention to provide a connector assembly which is secure and reliable, and in particular that enables connection status display for plug connector identification.

It is advantageous to provide a connector assembly which enables the user to have immediate visual identification showing that a plug connector is securely connected and powered up. Therefore, aspects of the invention are disclosed in independent claims 1 and 4.

For certain applications it is advantageous to provide a connector assembly which enables secure transfer of sensitive data and which can detect unauthorized or unapproved connectors.

For certain applications it is advantageous to provide a connector assembly that reduces cross-infection risks and streamlines tracking, restocking and inventory procedures.

For certain applications it is advantageous to provide a socket connector that provides information on repetitive use of a disposable plug connector to prevent defective connections.

Objects of this invention have been achieved by providing a socket connector according to claim 1.

Objects of the invention have been achieved by providing a method of controlling a connection history between a socket connector and a disposable plug connector according to claim 13.

Disclosed herein is an electrical socket connector for pluggable connection to a complementary plug connector, including a casing, a connection terminal assembly mounted in the casing for connection to a complementary connection terminal assembly of the plug connector, and an identification system. The identification system comprises a processing unit configured to read a plug identifier provided by an identifier module of the plug connector each time the socket and plug connectors are connected together, and a display unit with a light source for displaying a connection status based on said plug identifier read by the processing unit.

The display is ring shaped and surrounds a plug receiving cavity of the casing.

According to an embodiment, the light source comprises an array of light emitting diodes (LEDs) mounted on a circuit board.

According to an embodiment, the display unit may comprise a transparent or translucent flange, the array of LEDs being mounted behind the transparent or translucent flange and configured to generate two or more colors, each color indicative of the connection status.

According to an embodiment, the array of LEDs may comprise a plurality of multi-color LEDs arranged in a circle, for instance a plurality of bi-color LEDs arranged in a circle. The transparent or translucent flange may thus also be ring shaped.

According to an embodiment, the display unit is engraved with text to show a specific backlit sign such as "ON" or "OFF".

According to an embodiment, the socket connector further comprises supply wiring terminals mounted on the rear side of the connector for connecting the circuit board (e.g. printed circuit board) to a power source and to the ground.

The processing unit comprises a microcontroller comprising at least one input used to read the plug identifier received from the plug connector. There may be at least two outputs used to control the light source of the display.

The socket connector further comprises an electronic switch interconnected to one or more terminals of the connection terminal assembly, a microcontroller of the processing unit comprises an output connected to the electronic switch configured to control the electronic switch in order to connect or disconnect said one or more terminals based on the plug identifier read by said processing unit.

According to an embodiment, the electronic switch is in an open state prior to identification in which the socket and plug connectors are electrically disconnected from each other.

According to an embodiment, the processing unit comprises a circuit board on which said microcontroller, said electronic switch and said light source is mounted.

According to an advantageous embodiment, the circuit board is ring shaped.

According to an embodiment, the socket connector further comprises a heat sensor connected to the processing unit configured to monitor the temperature of the socket connector and to set the electronic switch to an open state when the temperature exceeds a predetermined value stored in a non-volatile memory of the connector.

According to an embodiment, the casing comprises an annular-shaped electronic components compartment surrounding a plug receiving cavity of the casing, the display unit having an annular shape and mounted in the electronic components compartment.

The processing unit comprises a non-volatile memory in which an identifier is pre-programmed, said identifier serving to authenticate said plug identifier.

According to an embodiment, the pre-programmed identifier may be a family identifier (ID) to authorize connection of a plurality of plugs having a plug identifier corresponding to said family ID.

According to an embodiment, the microcontroller of the processing unit may be configured to compare said read plug identifier with information received from the non-volatile memory and to process said information to approve or disapprove a connection by sending a voltage signal to the electronic switch and to the display.

According to an embodiment, a microcontroller of the processing unit may be configured to count a number of times a plug connector is plugged and unplugged from the socket connector and to store said number in a non-volatile memory of the processing unit.

According to an embodiment, the processing unit may be configured to distinguish between a number of times an authorized plug connector is plugged and unplugged from the socket connector from a number of times an unauthorized plug connector is plugged to the socket connector.

According to an embodiment, the processing unit may be configured to switch the electronic switch to an open state when said number reaches or exceeds a predetermined value stored in the non-volatile memory.

Also disclosed herein is an electrical socket connector for use in medical applications for pluggable connection to a complementary disposable plug connector, comprising a plug receiving portion, an identification and connection history control system for identification of the plug connector and for connection history control between the socket and plug connectors, and an electronic switch for secure authenticated connection between the socket and plug connectors, wherein the identification and connection history control system comprises a digital display unit for connection history status and a processing unit configured to read a plug identifier and an integer stored in a memory of the plug connector, said integer being correlated to the connection history between the socket and plug connectors, wherein the processing unit is further configured to modify the integer of the plug connector each time a secure connection is established between the socket and plug connectors, and to control the electronic switch and the digital display unit based on the plug identifier and integer outputs of the plug connector.

According to an example, the electronic switch is in an open state prior identification in which the socket and plug connectors are electrically disconnected from each other and wherein the processing unit ensures that the electronic switch always remains is an open state when said integer reaches or exceeds a predetermined value.

Also disclosed herein is an electrical plug connector for pluggable connection to a socket connector as set forth herein, the plug connector comprising an identifier module provided with a plug identifier and optionally a LED for displaying the connection status and/or a heat sensor.

Also disclosed herein according to an aspect of the invention is a connector pair assembly comprising the plug and socket connectors described above.

Also disclosed herein is a method of establishing a secure authenticated connection between a socket connector and a plug connector, comprising:
i) providing a socket connector and a plug connector;
ii) connecting the plug and socket connectors together;
iii) reading the plug identifier by the plug ID reader;
iv) controlling the electronic switch based on the read-out of the plug ID reader, and
v) setting the visual aspect of the display unit based on the read-out of the plug ID reader.

Also disclosed herein according to another aspect of the invention is a method of controlling secure connection history between a socket connector and a disposable plug connector, the socket connector comprising a plug ID reader and an electronic switch, the disposable plug connector comprising a plug identifier and a non-volatile memory in which is stored an integer representing a maximum number of allowed connection cycles between the plug connector and the socket connector, the method comprising the steps of:
i) connecting the plug and socket connectors together;
ii) reading of the plug identifier by the plug ID reader;
iii) determining whether the integer has reached a predetermined value if the read-out of plug ID reader is positive;
iv) modifying the integer stored in the memory of the plug connector each time a secure connection is established between the plug and socket connectors as long as the integer has not reached the predetermined value; and
v) setting the electronic switch to an open state when the integer has reached a predetermined value.

Further objects and advantageous effects of the invention will be apparent from the claims and from the following detailed description, and accompanying figures.

### Brief description of the figures

The invention will now be described with reference to the accompanying drawings which by way of examples illustrate embodiments of the present invention and in which:
Fig. 1 is a perspective view of a socket connector according to an embodiment of the invention;
Fig. 2 is a front view of the socket connector of Fig.1;
Fig. 3 is an axial cross-sectional view of the socket connector of Fig. 1;
Fig. 4 is a side view of the socket connector of Fig. 1;
Fig. 5 is an exploded view of the socket connector of Fig. 1;
Fig. 6 is a perspective view of the socket connector of Fig. 1 connected to a driving board according to an embodiment of the invention;
Fig. 7 is a cross-sectional view of a plug connector for mating with the socket connector of Fig. 1 according to an embodiment of the invention;
Fig. 8 is a schematic view of a connection between a plug and a socket connector according to an embodiment of the invention;
Fig.9 is a flowchart of an identification method for secure connection based on serial number comparison according to an embodiment of the invention;
Fig. 10 is a flowchart of a connection history control method for use in particular in a sterilized environment according to an embodiment of the invention; and
Fig. 11 is a flowchart of an identification method with electronic safeguards.

### Detailed description of the invention

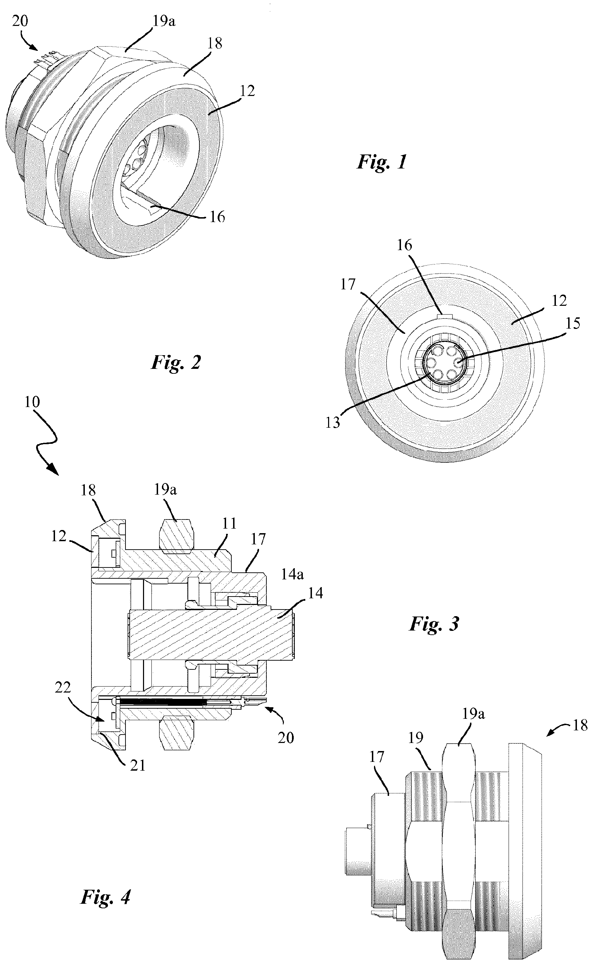

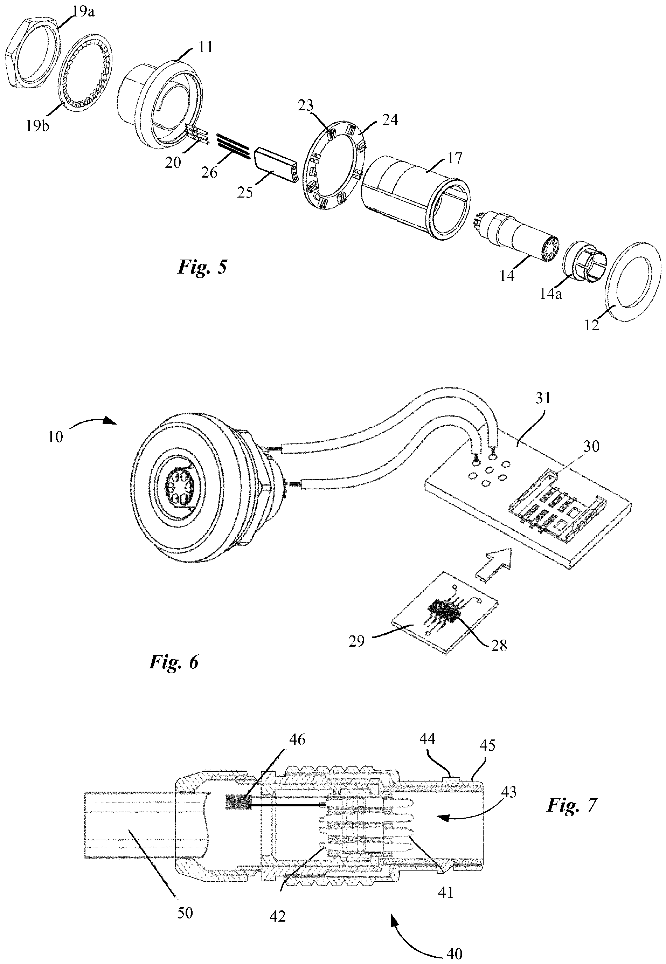

Referring to the figures, starting in particular with figures 3 and 5, a socket connector 10 comprises a casing 11, a tubular sleeve 17 fitted inside the casing, an annular display unit 12 (figures 1 & 2) which is transparent or translucent for displaying a wide spectrum of colors, and a connection terminal assembly 13 comprising a terminal housing 14 axially mounted within the tubular sleeve 17 and assembled therewith by means of a collet 14a. The terminal housing 14 is provided with receptacle terminals 15 for mating with pin contacts 41 partially mounted inside a terminal housing 42 of a complementary connection terminal assembly 43 of a plug connector 40 (figure 7) so as to ensure electrical connection between the plug and socket connectors when connected together.

The orientation and guiding of the socket connector 10 relative to the plug connector 40 is provided by a polarizing arrangement to ensure that the complementary connectors can only be plugged together in a certain angular orientation. The polarizing arrangement comprises a linear groove 16 arranged on the inner surface of the tubular sleeve 17 and adjacent the connection terminal assembly 13 of the socket connector and a corresponding protruding part 44 located on the outer surface of a protecting shell 45 of the plug connector. The groove 16 extends from the front side of the connector up to the terminal assembly for guiding the pin contacts of the plug connector into the receptacles terminals of the socket connector.

As best seen in figure 4, the casing comprises a flange 18 on the front side of the socket connector, a threaded exterior surface 19 for receiving a locknut 19a coupled to a washer 19b (figure 5) for fixing the socket connector to an electric/electronic device and power supply terminals 20 on the rear side of the connector. As shown in figure 3, the flange 18 comprises an annular recess provided with a ring shoulder 21 against which the annular display unit 12 is mounted to cover the entire recess thereby creating a substantially annular-shaped electronic components compartment 22 adjacent the display unit and which encloses a variety of electronic components.

In particular, several LEDs 23 of the display unit are mounted inside the electronic components compartment in order to display two different colors consecutively allowing the socket connector to indicate a connection status for diagnostics. In a preferred embodiment of the invention as shown in figure 5, bicolor LEDs (or tricolor LED's), configured to display preferably green and red colors, (or possibly white and red or other colors) are arranged behind the translucent flange of the display unit 12 on a printed circuit board 24 of general annular or ring shape such that an array of bicolor LEDs is arranged through 360° inside the electronic components compartment. The casing 11 comprises a cavity configured to receive a wire housing 25 comprising wires 26 which connect the annular circuit board 22 to the power supply terminals for connecting LEDs and other electronic components to a power source and to ground. The array of LEDs is driven as discussed below in detail so as to indicate whether:
- a secure (i.e authenticated) connection between the plug and socket connectors has been established through an identification method according to an embodiment of the invention, or
- a predetermined number of secure connection cycles between a disposal plug connector and a socket connector has been reached through an identification and connection history control method according to an embodiment of the invention.

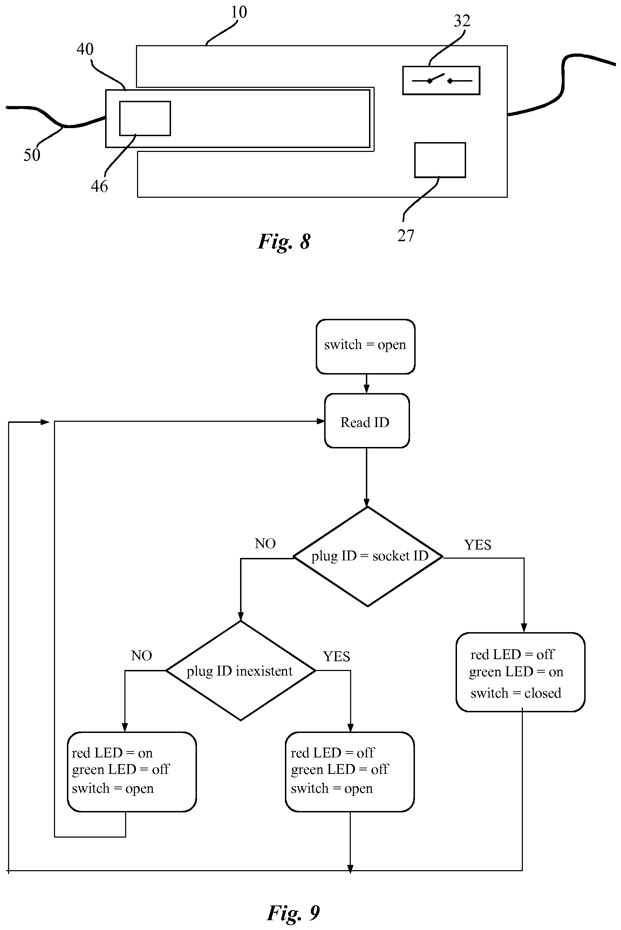

In an advantageous embodiment, a microcontroller and a non-volatile memory 27 (figure 8), e.g.an EEPROM, are mounted inside the electronic components compartment on the printed circuit board of the socket connector. In a variant illustrated in figure 6, a microcontroller 28 may be mounted on a support 29 configured to be fitted on a support holder 30 of a separate driving board 31 connected to the socket connector 10. The driving board may be installed preferably in an electronic/electric device/equipment coupled to the socket connector.

Referring to figures 7 and 8, the plug connector 40 is configured to be connected to an electrical cable or optical fiber 50 and comprises a non-volatile memory 46, such as EEPROM, electrically connected to at least one of the pin contacts 41 to allow a two-way communication between the microcontroller of the socket connector and the non-volatile memory of plug connector after plugging. The non-volatile memory 46 is pre-programmed with an identifier such as a serial number format (e.g. 48 bit serial number format) which is specific to a matching pair of plug and socket connectors. Advantageously, an electronic switch, for instance in the form of a relay 32, may be mounted on the printed circuit board inside the electronic components compartment of the socket connector. The relay is configured to be in an open state in which the socket connector is electrically disconnected from the plug connector or in a close state allowing a secure connection for transmission of sensitive data when the plug and socket connectors are connected together. The use of a relay allows the transfer of any kind of signal such as high speed data signal or high voltage signal and is particularly suited for the transmission of high volumes of data through optical fiber. Alternatively, the electronic switch may comprise a logic gate to perform the switching function

An identifier family can be pre-programmed on the non-volatile memory of multiple plug and socket connectors thus allowing multitude plug connectors to be securely connected (i.e. in an authenticated manner) to multiple socket connectors sharing the same identifier family.

Referring now to figure 9, the electronic switch is generally configured to be in an open state prior coupling the plug connector with the socket connecter. Connection between the plug and socket connectors triggers a signal ordering the microcontroller to determine whether the stored ID number in the plug's memory corresponds to the expected ID number. The ID number may be compared by the microcontroller with an ID number directly pre-programmed into the microcontroller or to an ID number stored in the non-volatile memory of the socket connector and retrieved by the microcontroller. If the two ID numbers match, the microcontroller sends a high voltage signal to the relay and to the array of green LEDs and a low voltage signal to the array of red LEDs thereby setting the relay to a close state allowing the transfer of secure data from the plug to the socket connectors on the one hand, and causing the display unit to turn green on the other hand. Conversely, if there is no match between the plug's ID number and the expected ID number, the microcontroller sends a low voltage signal to the relay and to the array of green LEDs and a high voltage signal to the array of red LEDs thereby causing the relay to remain open preventing the transfer of sensitive data between the plug and socket connectors on the one hand, and causing the display unit to turn red. In the configuration where the microcontroller cannot determine any valid ID number, the relay remains in an open state and the display unit remains red.

Accordingly, the secure connection through the identification method limits the use of the socket connector to all plug connectors comprising an ID number recognized by the microcontroller of the socket connector. The ID number may be stored in the non-volatile memory of the plug connector at the time of manufacture of the connector or at a later stage prior use.

In a preferred embodiment, the identification and connection history control method comprises a first stage of identification according to the above described method followed by a second stage in which the connection history between the plug and socket connectors is checked and in which the state of the relay of the socket connector is set according to the connection history status.

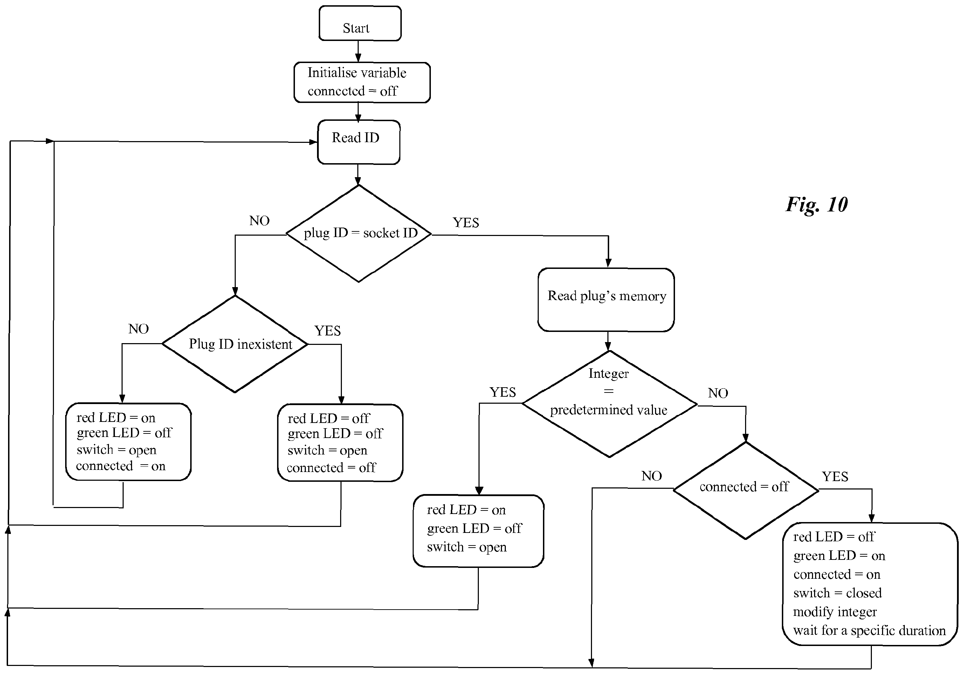

More particularly and with reference to figure 10, an integer (e.g. between 1 and 10) is stored in the non-volatile memory of the plug connector at the time of the manufacture or at a later stage prior use. This number corresponds advantageously to a maximum number of secure connection cycles that is possible to achieve with the plug connector prior disposal. A connection cycle must be understood within the context of the invention as an insertion of the plug connector into the socket connector with successful identification followed by the removal of the plug. This method is particularly suitable for connecting medical equipment used in sterilized environment where the lifespan of a plug connector is significantly reduced by premature wear caused by aggressive chemical compositions that can be corrosive to materials in case of repeated sterilization cycles.

When a plug connector, with an exemplary initial integer of 10 stored on its memory, is connected to the socket connector for the first time and after successful completion of the identification stage, the microcontroller reads the integer stored in the plug's memory and sends a high voltage signal to the relay and to the array of green LED's and a low voltage signal to the array of red LED's thereby setting the relay to a closed state allowing the transfer of secure data from the plug to the socket connectors on the one hand, and causing the display unit to turn green on the other hand. The microcontroller also sets the integer value at 9. In an advantageous embodiment, the microcontroller modifies the integer after a predefined period of time, in the order of a few milliseconds or microseconds, in order to ensure that micro-power cuts that may occur when connecting the plug and socket connectors together do not modify the integer. Once the predefined period of time has elapsed, the microcontroller verifies that the plug is connected by continuously checking the plug's ID number with the ID number(s) stored in a non-volatile memory of the socket connector, such that, as long as the plug connector remains connected, the microcontroller does not modify the integer stored in the plug's memory. In the configuration where the device to which the plug is connected is turned off and on, the microcontroller also modifies the integer stored in the plug's memory. When the integer reaches the predetermined value, after several connections between the plug and socket connectors, the microcontroller sends a low voltage signal to the relay and to the array of green LED's and a high voltage signal to the array of red LED's thereby setting the relay to an open state thus preventing further electrical connections between the socket connector and the disposal plug connector on the one hand, and causing the display unit to turn red on the other hand which indicates that the disposal plug connector may be discarded.

Advantageously, the array of LED's of the socket connector as described above is replaced by at least one digital display unit consisting of seven segments in order to display a countdown of the remaining connection cycles before disposal of the plug connector. The digital unit may display the letter "*E*" for error or "*F*" for failure when the predetermined value has been reached.

For this specific application, the socket connector comprises a cylindrical plug receiving portion and a digital display receiving portion comprising the digital display unit. The plug receiving portion and the digital display receiving portion form together a single-piece casing.

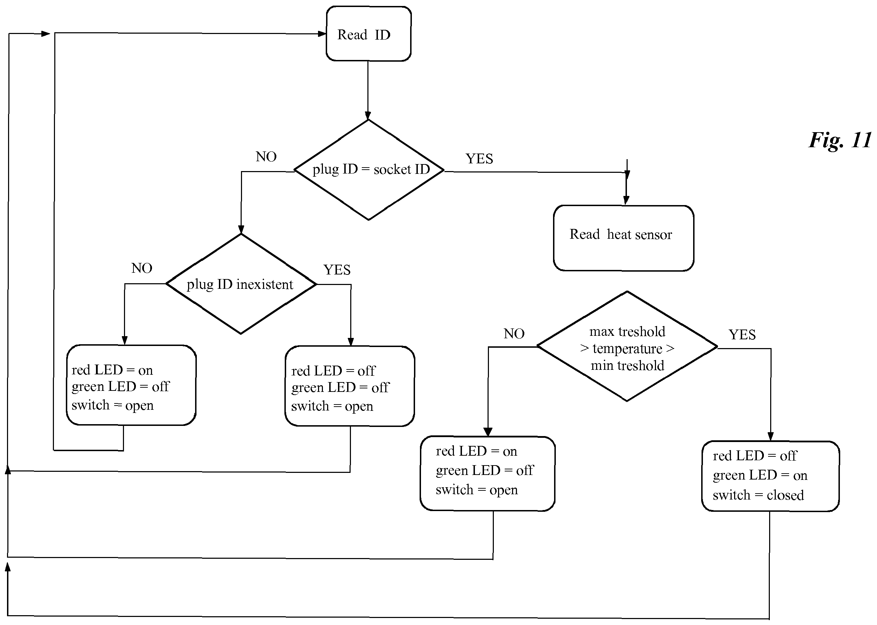

Referring to figure 11, the socket connector or the plug connector may also comprise a heat sensor configured to monitor the temperature of the connectors when coupled together and to set the electronic switch/relay to an open state when the temperature exceeds a predetermined value. In another embodiment, the plug connector may further comprise a light emitting diode (LED) for displaying the connection status and may be configured for pluggable connection with a computer for storing and/or retrieving sensitive data from the computer based on the identification method as previously described.

### List of references

Socket-type connector 10
   casing 11
      electronic components compartment 22
      tubular sleeve 17
      flange 18
         ring shoulder 21
      threaded exterior surface 19
      keying arrangement
         key element e.g. groove, slot 16
   connection terminal assembly 13
      terminal housing 14
      collet 14a
      terminals 15
         receptacle terminals
   identification system (1emb)/ identification and connection history control system (2emb)
      processing unit
         plug reader
         microcontroller (1emb.)
         memory 27
      display unit 12/digital display
         circuit board 24
         light source
            LED's 23
            display electrical supply
               power supply terminals 20
               wire housing 25
               wire 26
   electronic switch
      relay 32
      logic gate
   nut
      locknut 19a
      washer 19b
   microcontroller 28 (1emb.)
      support 29
      support holder 30
      driving board 31
   heat sensor
Plug-type connector 40
   protecting shell 45
   complementary connection terminal assembly 43
      terminal housing 42
         pin contact 41
      keying arrangement
         complementary protruding part 44
   identifier module
      plug identifier
      circuit component (e.g. integrated circuit)
      non-volatile memory 46
      ID code stored in memory
   USB key
   optical fiber 50

## Claims

1. Electrical socket connector (10) for pluggable connection to a complementary plug connector (40), and configured to be mounted in an electronic/electric device or equipment, the socket connector (10) including a casing (11), a connection terminal assembly (13) mounted in the casing (11) for connection to a complementary connection terminal assembly (43) of the plug connector (40), an electronic switch (32) interconnected to one or more terminals (15) of the connection terminal assembly (13), an identification system comprising a processing unit configured to read a plug identifier provided by an identifier module (46) of the plug connector (40) each time the socket and plug connectors (10, 40) are connected together, the processing unit comprising a microcontroller (28) comprising an output connected to the electronic switch (32) and at least one input used to read the plug identifier in order to control the electronic switch (32) to connect or disconnect said one or more terminals (15) based on the plug identifier, the processing unit further comprising a non-volatile memory (27) in which an identifier is pre-programmed, said identifier serving to authenticate said plug identifier, and a ring-shaped display unit (12) surrounding a plug receiving cavity of the casing (11) with a light source (23) for displaying a connection status based on said plug identifier read by the processing unit.

2. Socket connector (10) according to claim 1, wherein the casing (11) comprises a threaded exterior surface (19) for receiving a locknut (19a).

3. Socket connector (10) according to any preceding claim, wherein the light source (23) comprises an array of light emitting diodes (LEDs) mounted on a circuit board (24), wherein the display unit (12) comprises a transparent or translucent flange, the array of LEDs being mounted behind the transparent or translucent flange and configured to generate two or more colors, each color indicative of the connection status.

4. Socket connector (10) according to any preceding claim, wherein the display unit (12) is engraved with text to show a specific backlit sign such as "ON" or "OFF".

5. Socket connector (10) according to any preceding claim, wherein the electronic switch (32) is in an open state prior to identification in which the socket and plug connectors (10, 40) are electrically disconnected from each other.

6. Socket connector (10) according to any preceding claim, further comprising a heat sensor connected to the processing unit configured to monitor the temperature of the socket connector (10) and to set the electronic switch (32) to an open state when the temperature exceeds a predetermined value stored in the non-volatile memory (27) of the socket connector (10).

7. Socket connector (10) according to any preceding claim, wherein said pre-programmed identifier is a family identifier (ID) to authorize connection of a plurality of plugs having a plug identifier corresponding to said family ID.

8. Socket connector (10) according to any preceding claim, wherein the microcontroller (28) of the processing unit is configured to compare said read plug identifier with information received from the non-volatile memory (27) and to process said information to approve or disapprove a connection by sending a voltage signal to the electronic switch (32) and to the display unit (12).

9. Socket connector (10) according to any preceding claim, wherein the microcontroller (28) of the processing unit is configured to count a number of times a plug connector (40) is plugged and unplugged from the socket connector (10) and to store said number in the non-volatile memory (27) of the processing unit.

10. Socket connector (10) according to the preceding claim, wherein the processing unit is configured to distinguish between a number of times an authorized plug connector (40) is plugged and unplugged from the socket connector (10) from a number of times an unauthorized plug connector (40) is plugged to the socket connector (10).

11. Socket connector (10) according to either of the two directly preceding claims, wherein the processing unit is configured to switch the electronic switch (32) to an open state when said number reaches or exceeds a predetermined value stored in the non-volatile memory (27).

12. Connector pair assembly comprising the socket connector (10) according to any one of claims 1 to 11 and a plug connector (40) for pluggable connection to a socket connector (10) according to any one of the preceding claims, the plug connector (40) comprising an identifier module (46) provided with a plug identifier and optionally a LED (23) for displaying the connection status and/or a heat sensor.

13. Method of controlling secure connection history between a socket connector (10) and a disposable plug connector (40), the socket connector (10) comprising a plug ID reader and an electronic switch (32), the disposable plug connector (40) comprising a plug identifier and a non-volatile memory (46) in which is stored an integer representing a maximum number of allowed connection cycles between the plug connector (40) and the socket connector (10), the method comprising the steps of:
i) connecting the plug and socket connectors (10, 40) together;
ii) reading the plug identifier by the plug ID reader;
iii) determining whether the integer has reached a predetermined value if the read-out of plug ID reader is positive;
iv) modifying the integer stored in the memory of the plug connector (40) each time a secure connection is established between the plug and socket connectors (10, 40) as long as the integer has not reached the predetermined value; and
v) setting the electronic switch (32) to an open state when the integer has reached a predetermined value.

14. Method according to the preceding claim further comprising providing a socket connector (10) according to any one of preceding claims 1-11.

## Patentansprüche

1. Elektrischer Buchsenverbinder (10) für eine steckbare Verbindung mit einem ergänzenden Steckerverbinder (40) und dazu ausgelegt, in eine elektronische/elektrische Vorrichtung oder Ausrüstung montiert zu werden, wobei der Buchsenverbinder (10) ein Gehäuse (11), eine Verbindungsanschlussanordnung (13), die zur Verbindung mit einer ergänzenden Verbindungsanschlussanordnung (43) des Steckerverbinders (40) im Gehäuse (11) montiert ist, einen elektronischen Schalter (32), der an einen oder mehrere Anschlüsse (15) der Verbindungsanschlussanordnung (13) gekoppelt ist, ein Identifikationssystem, das eine Verarbeitungseinheit umfasst, die dazu ausgelegt ist, eine Steckerkennung zu lesen, die von einem Kennungsmodul (46) des Steckerverbinders (40) jedes Mal bereitgestellt wird, wenn der Buchsen- und der Steckerverbinder (10, 40) miteinander verbunden werden, wobei die Verarbeitungseinheit eine Mikrosteuerung (28) umfasst, die einen Ausgang, der mit dem elektronischen Schalter (32) verbunden ist, und mindestens einen Eingang, der verwendet wird, um die Steckerkennung zu lesen, um den elektronischen Schalter (32) zu steuern, um den einen oder die mehreren Anschlüsse (15) auf Basis der Steckerkennung zu verbinden oder zu trennen, umfasst, wobei die Verarbeitungseinheit ferner einen nichtflüchtigen Speicher (27) umfasst, in dem eine Kennung vorprogrammiert ist, wobei die Kennung der Authentifizierung der Steckerkennung dient, sowie eine ringförmige Anzeigeeinheit (12), die einen Steckeraufnahmehohlraum des Gehäuses (11) mit einer Lichtquelle (23) zum Anzeigen eines Verbindungsstatus auf Basis der von der Verarbeitungseinheit gelesenen Steckerkennung umgibt, beinhaltet.

2. Buchsenverbinder (10) nach Anspruch 1, wobei das Gehäuse (11) eine Außengewindefläche (19) zum Aufnehmen einer Sicherungsmutter (19a) umfasst.

3. Buchsenverbinder (10) nach einem der vorhergehenden Ansprüche, wobei die Lichtquelle (23) ein Array von lichtemittierenden Dioden (LEDs), die auf einer Leiterplatte (24) montiert sind, umfasst, wobei die Anzeigeeinheit (12) einen transparenten oder durchscheinenden Flansch umfasst, wobei das Array von LEDs hinter dem transparenten oder durchscheinenden Flansch montiert und dazu ausgelegt ist, zwei oder mehrere Farben zu erzeugen, wobei jede Farbe den Verbindungsstatus anzeigt.

4. Buchsenverbinder (10) nach einem der vorhergehenden Ansprüche, wobei in die Anzeigeeinheit (12) Text eingraviert ist, der ein spezifisches von hinten beleuchtetes Zeichen zeigt, wie etwa "EIN" oder "AUS".

5. Buchsenverbinder (10) nach einem der vorhergehenden Ansprüche, wobei sich der elektronische Schalter (32) vor der Identifizierung in einem offenen Zustand befindet, in dem der Buchsen- und der Steckerverbinder (10, 40) elektrisch voneinander getrennt sind.

6. Buchsenverbinder (10) nach einem der vorhergehenden Ansprüche, der ferner einen Wärmesensor umfasst, der mit der Verarbeitungseinheit verbunden ist, die dazu ausgelegt ist, die Temperatur des Buchsenverbinders (10) zu überwachen und den elektronischen Schalter (32) auf einen offenen Zustand einzustellen, wenn die Temperatur einen vorbestimmten Wert, der im nichtflüchtigen Speicher (27) des Buchsenverbinders (10) gespeichert ist, überschreitet.

7. Buchsenverbinder (10) nach einem der vorhergehenden Ansprüche, wobei die vorprogrammierte Kennung eine Familienkennung (ID) zum Autorisieren der Verbindung einer Vielzahl von Steckern, die eine Steckerkennung aufweisen, die der Familien-ID entspricht, ist.

8. Buchsenverbinder (10) nach einem der vorhergehenden Ansprüche, wobei die Mikrosteuerung (28) der Verarbeitungseinheit dazu ausgelegt ist, die gelesene Steckerkennung mit Informationen, die vom nichtflüchtigen Speicher (27) empfangen werden, zu vergleichen und die Informationen zu verarbeiten, um durch Senden eines Spannungssignals an den elektronischen Schalter (32) und die Anzeigeeinheit (12) eine Verbindung zu genehmigen oder abzulehnen.

9. Buchsenverbinder (10) nach einem der vorhergehenden Ansprüche, wobei die Mikrosteuerung (28) der Verarbeitungseinheit dazu ausgelegt ist, eine Anzahl der Häufigkeit, mit der ein Steckerverbinder (40) in den Buchsenverbinder (10) eingesteckt oder aus diesem abgezogen wird, zu zählen und die Anzahl im nichtflüchtigen Speicher (27) der Verarbeitungseinheit zu speichern.

10. Buchsenverbinder (10) nach dem vorhergehenden Anspruch, wobei die Verarbeitungseinheit dazu ausgelegt ist, zwischen einer Anzahl der Häufigkeit, mit der ein autorisierter Steckerverbinder (40) in den Buchsenverbinder (10) eingesteckt und aus diesem abgezogen wird, und einer Anzahl der Häufigkeit, mit der ein nicht autorisierter Steckerverbinder (40) in den Buchsenverbinder (10) eingesteckt wird, zu unterscheiden.

11. Buchsenverbinder (10) nach einem der zwei direkt vorhergehenden Ansprüche, wobei die Verarbeitungseinheit dazu ausgelegt ist, den elektronischen Schalter (32) in einen offenen Zustand zu schalten, wenn die Anzahl einen vorbestimmten Wert, der im nichtflüchtigen Speicher (27) gespeichert ist, erreicht oder überschreitet.

12. Verbinderpaaranordnung, die den Buchsenverbinder (10) nach einem der Ansprüche 1 bis 11 und einen Steckerverbinder (40) für eine steckbare Verbindung mit einem Buchsenverbinder (10) nach einem der vorhergehenden Ansprüche umfasst, wobei der Steckerverbinder (40) ein Kennungsmodul (46), das mit einer Steckerkennung versehen ist, und wahlweise eine LED (23) zum Anzeigen des Verbindungsstatus und/oder einen Wärmesensor umfasst.

13. Verfahren zum Steuern eines sicheren Verbindungsverlaufs zwischen einem Buchsenverbinder (10) und einem Einwegsteckerverbinder (40), wobei der Buchsenverbinder (10) einen Stecker-ID-Leser und einen elektronischen Schalter (32) umfasst, wobei der Einwegsteckerverbinder (40) eine Steckerkennung und einen nichtflüchtigen Speicher (46), in der eine Ganzzahl gespeichert ist, die eine maximale Anzahl von erlaubten Verbindungszyklen zwischen dem Steckerverbinder (40) und dem Buchsenverbinder (10) repräsentiert, umfasst, wobei das Verfahren die folgenden Schritte umfasst:
i) Verbinden des Stecker- und des Buchsenverbinders (10, 40) miteinander;
ii) Lesen der Steckerkennung durch den Stecker-ID-Leser;
iii) Bestimmen, ob die Ganzzahl einen vorbestimmten Wert erreicht hat, wenn das Auslesen des Stecker-ID-Lesers positiv ist;
iv) Modifizieren der im Speicher des Steckerverbinders (40) gespeicherten Ganzzahl jedes Mal, wenn eine sichere Verbindung zwischen dem Stecker- und dem Buchsenverbinder (10, 40) hergestellt wird, solange die Ganzzahl den vorbestimmten Wert nicht erreicht hat; und
v) Einstellen des elektronischen Schalters (32) auf einen offenen Zustand, wenn die Ganzzahl einen vorbestimmten Wert erreicht hat.

14. Verfahren nach einem der vorhergehenden Ansprüche, das ferner das Bereitstellen eines Buchsenverbinders (10) nach einem der vorhergehenden Ansprüche 1-11 umfasst.

## Revendications

1. Connecteur femelle (10) électrique pour une connexion enfichable à un connecteur mâle (40) complémentaire, et configuré pour être monté dans un dispositif ou équipement électronique/électrique, le connecteur femelle (10) comportant un boîtier (11), un ensemble de bornes de connexion (13) monté dans le boîtier (11) pour une connexion à un ensemble de bornes de connexion complémentaire (43) du connecteur mâle (40), un commutateur électronique (32) interconnecté à une ou plusieurs bornes (15) de l'ensemble de bornes de connexion (13), un système d'identification comprenant une unité de traitement configurée pour lire un identifiant de fiche fourni par un module d'identifiant (46) du connecteur mâle (40) chaque fois que les connecteurs femelle et mâle (10, 40) sont connectés l'un à l'autre, l'unité de traitement comprenant une micro-unité de commande (28) comprenant une sortie connectée au commutateur électronique (32) et au moins une entrée utilisée pour lire l'identifiant de fiche afin de commander le commutateur électronique (32) pour connecter ou déconnecter lesdites une ou plusieurs bornes (15) sur la base de l'identifiant de fiche, l'unité de traitement comprenant en outre une mémoire non volatile (27) dans laquelle un identifiant est préprogrammé, ledit identifiant servant à authentifier ledit identifiant de fiche, et une unité d'affichage en forme d'anneau (12) entourant une cavité de réception de fiche du boîtier (11) avec une source de lumière (23) pour afficher un statut de connexion sur la base dudit identifiant de fiche lu par l'unité de traitement.

2. Connecteur femelle (10) selon la revendication 1, dans lequel le boîtier (11) comprend une surface extérieure filetée (19) pour recevoir un contre-écrou (19a).

3. Connecteur femelle (10) selon l'une quelconque des revendications précédentes, dans lequel la source de lumière (23) comprend un réseau de diodes électroluminescentes (DEL) montées sur une carte de circuit imprimé (24), dans lequel l'unité d'affichage (12) comprend une bride transparente ou translucide, le réseau de DEL étant monté derrière la bride transparente ou translucide et configuré pour générer deux ou plusieurs couleurs, chaque couleur indiquant le statut de connexion.

4. Connecteur femelle (10) selon l'une quelconque des revendications précédentes, dans lequel l'unité d'affichage (12) est gravée d'un texte pour montrer un signe spécifique rétroéclairé tel que "MARCHE" ou "ARRÊT".

5. Connecteur femelle (10) selon l'une quelconque des revendications précédentes, dans lequel le commutateur électronique (32) est dans un état ouvert avant l'identification dans lequel les connecteurs femelle et mâle (10, 40) sont électriquement déconnectés l'un de l'autre.

6. Connecteur femelle (10) selon l'une quelconque des revendications précédentes, comprenant en outre un capteur de chaleur connecté à l'unité de traitement configurée pour surveiller la température du connecteur femelle (10) et pour régler le commutateur électronique (32) sur un état ouvert lorsque la température dépasse une valeur prédéterminée stockée dans la mémoire non volatile (27) du connecteur femelle (10).

7. Connecteur femelle (10) selon l'une quelconque des revendications précédentes, dans lequel ledit identifiant préprogrammé est un identifiant (ID) de famille pour autoriser la connexion d'une pluralité de fiches ayant un identifiant de fiche correspondant audit ID de famille.

8. Connecteur femelle (10) selon l'une quelconque des revendications précédentes, dans lequel la micro-unité de commande (28) de l'unité de traitement est configurée pour comparer ledit identifiant de fiche lu avec des informations reçues à partir de la mémoire non volatile (27) et pour traiter lesdites informations pour approuver ou rejeter une connexion en envoyant un signal de tension au commutateur électronique (32) et à l'unité d'affichage (12).

9. Connecteur femelle (10) selon l'une quelconque des revendications précédentes, dans lequel la micro-unité de commande (28) de l'unité de traitement est configurée pour compter le nombre de fois où un connecteur mâle (40) est branché et débranché du connecteur femelle (10) et pour stocker ledit nombre dans la mémoire non volatile (27) de l'unité de traitement.

10. Connecteur femelle (10) selon la revendication précédente, dans lequel l'unité de traitement est configurée pour distinguer entre un nombre de fois où un connecteur mâle (40) autorisé est branché et débranché du connecteur femelle (10) un nombre de fois où un connecteur mâle (40) non autorisé est branché au connecteur femelle (10).

11. Connecteur femelle (10) selon l'une quelconque des deux revendications directement précédentes, dans lequel l'unité de traitement est configurée pour commuter le commutateur électronique (32) vers un état ouvert lorsque ledit nombre atteint ou dépasse une valeur prédéterminée stockée dans la mémoire non volatile (27).

12. Ensemble de paire de connecteurs comprenant le connecteur femelle (10) selon l'une quelconque des revendications 1 à 11 et un connecteur mâle (40) pour une connexion enfichable à un connecteur femelle (10) selon l'une quelconque des revendications précédentes, le connecteur mâle (40) comprenant un module d'identifiant (46) muni d'un identifiant de fiche et éventuellement d'une DEL (23) pour afficher le statut de connexion et/ou d'un capteur de chaleur.

13. Procédé de commande d'un historique de connexion sécurisé entre un connecteur femelle (10) et un connecteur mâle (40) jetable, le connecteur femelle (10) comprenant un lecteur d'ID de fiche et un commutateur électronique (32), le connecteur mâle (40) jetable comprenant un identifiant de fiche et une mémoire non volatile (46) dans laquelle est stocké un entier représentant un nombre maximal de cycles de connexion autorisés entre le connecteur mâle (40) et le connecteur femelle (10), le procédé comprenant les étapes consistant à :
i) connecter les connecteurs mâle et femelle (10, 40) l'un à l'autre ;
ii) lire l'identifiant de fiche par le lecteur d'ID de fiche ;
iii) déterminer si l'entier a atteint une valeur prédéterminée si la lecture du lecteur d'ID de fiche est positive ;
iv) modifier le nombre entier stocké dans la mémoire du connecteur mâle (40) chaque fois qu'une connexion sécurisée est établie entre les connecteurs mâle et femelle (10, 40) tant que le nombre entier n'a pas atteint la valeur prédéterminée ; et
v) régler le commutateur électronique (32) sur un état ouvert lorsque l'entier a atteint une valeur prédéterminée.

14. Procédé selon la revendication précédente comprenant en outre le fait de fournir un connecteur femelle (10) selon l'une quelconque des revendications précédentes 1 à 11.
